# EUROPEAN PATENT SPECIFICATION

(11) **EP 3 396 422 B1**
(45) Date of publication and mention of the grant of the patent: **02.09.2020**
(21) Application number: 16878262.1
(22) Date of filing: 28.11.2016
(51) Int. Cl.: G02B 5/08, B32B 15/08, B32B 27/36, C08L 67/00, C23C 14/14, C23C 14/20, F21V 7/24

(54) **LIGHT REFLECTOR**
LICHTREFLEKTOR
RÉFLECTEUR DE LUMIÈRE

(30) Priority: 25.12.2015 JP 2015254185
(43) Date of publication of application: 31.10.2018
(73) Proprietor: Shiraishi Kogyo Kaisha, Ltd., Osaka-shi Osaka 541-0041 (JP)
(72) Inventor: EGUCHI, Kenichiro, Amagasaki-shi Hyogo 660-0085 (JP); MINAMINO, Yutaka, Amagasaki-shi Hyogo 660-0085 (JP)
(74) Representative: Ter Meer Steinmeister & Partner
(86) International application number: PCT/JP2016/085103
(87) International publication number: WO 2017/110368

(56) References cited:
- WO-A1-2016/002831
- JP-A- 2008 280 498
- JP-A- 2016 027 148
- US-A1- 2006 291 215

## Description

### Technical Field

The present invention relates to light reflectors in which a light reflection layer is provided on a base material made of a polyester resin composition.

### Background Art

As light reflectors, such as reflectors or extensions for use in motor vehicle lamps or others, consideration has heretofore been made of light reflectors in which a light reflection layer, such as a vapor-deposited metal film, is provided on a base material made of a polyester resin composition. In these light reflectors, an inorganic filler is added to the polyester resin in order to increase the thermal resistance or other properties of the base material.

In Patent Literature 1, talc, barium sulfate, calcium carbonate and/or titanium oxide are added to the polyester resin. In Patent Literature 2, fired kaolin is combined with barium sulfate or titanium oxide as inorganic fillers. Furthermore, in Patent Literature 3, fired kaolin and talc are added to the polyester resin. Patent Literature 4 discloses in the examples a polyester compositions which are subsequently used as a base material for a light reflector comprising the base material and a light reflection layer provided on the base material. The polyester compositions comprise PBT, PET and surface treated CaCO3 with an average particle diameter of 0.15 µm.

### Citation List

### Patent Literature

Patent Literature 1: WO 2012/147871
Patent Literature 2: JP-A-2007-161978
Patent Literature 3: JP-A-2008-280498
Patent Literature 4: US 2006/291215 A1

### Summary of Invention

### Technical Problem

However, the inorganic filler has not been well considered from the viewpoint of high light intensity.

An object of the present invention is to provide a light reflector that can achieve high light intensity.

### Solution to Problem

The present invention is directed to a light reflector including a base material made of a polyester resin composition and a light reflection layer provided on the base material, wherein the polyester resin composition contains calcium carbonate having an average particle diameter of 0.1 to 0.3 µm.

The calcium carbonate is preferably contained in an amount of 1 to 40 parts by mass per 100 parts by mass of polyester resin.

The polyester resin preferably contains polybutylene terephthalate resin.

The light reflection layer is preferably a vapor-deposited metal film.

### Advantageous Effects of Invention

The present invention enables the provision of a light reflector that can achieve high light intensity.

### Description of Embodiments

The present invention will be described in more detail. However, the present invention is not limited by the following description.

### <Calcium Carbonate>

Calcium carbonate for use in the present invention has an average particle diameter within a range of 0.1 to 0.3 µm. If the average particle diameter is out of this range, sufficiently high light intensity cannot be achieved. The average particle diameter of calcium carbonate is more preferably within a range of 0.1 to 0.25 µm and particularly preferably within a range of 0.1 to 0.2 µm.

In the present invention, the average particle diameter can be measured by image analysis of electron micrographs or other means.

Synthetic calcium carbonate is preferably used as calcium carbonate. Synthetic calcium carbonate can be produced, for example, by reacting calcium hydroxide with carbon dioxide. Calcium hydroxide can be produced, for example, by reacting calcium oxide with water. Calcium oxide can be produced, for example, by mixing raw limestone with coke or the like and firing the mixture. In this case, because carbon dioxide generates during firing, calcium carbonate can be produced by blowing the carbon dioxide into a water suspension of calcium hydroxide to react carbon dioxide with calcium hydroxide.

The synthetic calcium carbonate preferably contains calcite crystals. Furthermore, the synthetic calcium carbonate preferably has an approximately cubic shape.

The calcium carbonate may be subjected to a surface treatment as needed. Examples of the surface treatment include a surface treatment with an organic acid, such as a fatty acid or a resin acid, silica treatment, condensed phosphate treatment, and a treatment with a silane-based treating agent, an organic titanate or the like. These surface treatments may be used in combination. Examples of the silane-based treating agent include silane coupling agents, monomers of organic silicon compounds, and denatured silicone oils.

Because calcium carbonate has a smaller specific gravity than barium sulfate and talc, the use of calcium carbonate as an inorganic filler enables weight reduction of a light reflector.

### <Polyester Resin>

The preferred polyester resin to be used in the present invention is an aromatic polyester resin. Examples of the aromatic polyester resin include polyethylene terephthalate resin (PET), polypropylene terephthalate resin, polybutylene terephthalate resin (PBT), polyethylene naphthalate resin (PEN), polybutylene naphthalate resin (PBN), poly(cyclohexane-1,4-dimethylene terephthalate) resin, and polytrimethylene terephthalate resin, of which the preferred is polybutylene terephthalate resin.

Copolymers or mixtures of these polyester resins may be used. The copolymers and mixtures include, for example, alkylene terephthalate copolymers having an alkylene terephthalate building block as an essential building block and polyalkylene terephthalate mixtures containing polyalkylene terephthalate as a main component. Alternatively, a polyester resin containing or copolymerized with an elastomer component, such as polyoxytetramethylene glycol (PTMG), may be used.

The polyalkylene terephthalate mixtures include, for example, mixtures of PBT and any polyalkylene terephthalate other than PBT and mixtures of PBT and any alkylene terephthalate copolyester other than PBT. Preferred among them are a mixture of PBT and PET, a mixture of PBT and polytrimethylene terephthalate, and a mixture of PBT and PBT/polyalkylene isophthalate.

### <Polyester Resin Composition>

The polyester resin composition in the present invention contains the above-described calcium carbonate having an average particle diameter of 0.1 to 0.3 µm. The content of calcium carbonate is, per 100 parts by mass of polyester resin, preferably 1 to 40 parts by mass, more preferably 3 to 30 parts by mass, and particularly preferably 7 to 20 parts by mass. If the content of calcium carbonate is small or large, the surface smoothness may be lost, so that a high-intensity light reflector may not be able to be obtained.

The polyester resin composition in the present invention may contain, without impairing the object of the present invention, any resin other than polyester resin, and/or usual additives, such as an antioxidant, a heat stabilizer, an ultraviolet ray absorber, a fibrous reinforcing agent, a lubricant, a flame retardant, an antistat, a colorant, and a pigment. The content of these additives is preferably 10% by mass or less in the polyester resin composition in the present invention. Furthermore, without impairing the object of the present invention, the polyester resin composition may contain an inorganic filler other than the above-described calcium carbonate.

The polyester resin composition in the present invention can be obtained by mixing and kneading the above-described components by any method known in the prior art. The mixing and kneading method can be implemented by a method using, for example, a ribbon blender, a Henschel mixer, a Banbury mixer, a drum tumbler, a mono-screw extruder, a twin-screw extruder, a cokneader or a multi-screw extruder. The heating temperature during kneading is determined by appropriate selection.

### <Base Material>

The base material in the present invention can be produced by molding the above-described polyester resin composition. No particular limitation is placed on the molding method and, for example, molding methods known in the prior art can be used. Specific examples of the molding method include injection molding, gas-assisted injection molding, hollow molding, extrusion, compression molding, calendering, and rotational molding. Among them, injection molding is particularly preferably used.

### <Light Reflection Layer>

The light reflector according to the present invention can be produced by providing a light reflection layer on the above-described base material. The light reflection layer can be obtained, for example, by subjecting the base material to metal vapor deposition to form a metallic layer. There is no particular limitation as to the method for metal vapor deposition and any method therefor known in the prior art can be used. Examples of the metal to be vapor deposited include aluminum, chromium, and nickel, of which the preferred is aluminum.

The light reflection layer is preferably formed directly on the base material. Thus, the production process can be simplified. However, the light reflection layer may be formed after the base material is subjected to undercoating or primer treatment.

Although the vapor-deposited metal film has been described as the light reflection layer, the light reflection layer in the present invention is not limited to the vapor-deposited metal film and may be a light reflection layer formed by any other method.

There is no particular limitation as to the thickness of the light reflection layer and the thickness is appropriately determined according to the reflective performance or the like required for the light reflector.

### <Light Reflector>

The light reflector according to the present invention can be produced by providing the above-described light reflection layer on the above-described base material. The light reflector according to the present invention can be particularly preferably used as a housing, a reflector or an extension of a lamp for a motor vehicle or the like. However, the use of the light reflector according to the present invention is not limited to this and, for example, the light reflector can be applied as a light reflector for use in a home lighting system or the like.

### Examples

A description will be given below of examples to explain the present invention more specifically, but the present invention is not limited to the following examples without departing from the scope of the present invention.

The following are components used in Examples and Comparative Examples.

Calcium carbonate: six types of non-surface-treated synthetic calcium carbonate having respective average particle diameters of 0.08 µm, 0.1 µm, 0.15 µm, 0.2 µm, 0.3 µm, and 0.5 µm, having an approximately cubic shape, and containing calcite crystals
Talc: SG-95 (manufactured by Nippon Talc Co., Ltd.) having an average particle diameter of 2 µm
Clay: Satintone 5HB (manufactured by BASF Corporation) having an average particle diameter of 0.8 µm

### (Example 1)

### [Production of Base Material]

An amount of 80 parts by mass of polybutylene terephthalate resin (PBT), 20 parts by mass of polyethylene terephthalate resin (PET), and 10 parts by mass of calcium carbonate having an average particle diameter of 0.1 µm (measured by image analysis of an electron micrograph) as an inorganic filler were compounded and mixed homogeneously with a blender, and then loaded into a twin screw extruder at a cylinder temperature of 280°C, thus obtaining pellets of a polyester resin composition. The obtained pellets were injection molded with an injection molder, thus obtaining a molded article (60 mm × 60 mm × 2 mm) serving as a base material.

### [Measurement of Gloss of Base Material Surface]

The obtained base material was measured in terms of the glossiness of the base material surface on which a light reflection layer is to be formed by metal vapor deposition. In this relation, the base material was subjected to a heat treatment and the base material surface before the heat treatment and the base material surface after the heat treatment were measured in terms of glossiness. Because a base material is heated when subjected to metal vapor deposition as a later process, the above heat treatment is a heat treatment done as a correspondence to the heating of the base material in this process. The heat treatment was done under conditions of heating at 120°C for two hours.

In the measurement of glossiness, a parallel-beam glossmeter conforming to the specular glossiness measurement method (JIS Z 8741) was used. The measurement results are shown in Table 1.

### [Production of Light Reflector]

Using the base material not subjected to the heat treatment, aluminum was vacuum deposited on the surface of the base material to produce a light reflector. The thickness of the deposited aluminum film was approximately 0.1 µm.

The glossiness of the light-reflecting surface of the obtained light reflector was measured in the same manner as described above. The measurement result is shown in Table 1.

### (Example 2)

A base material and a light reflector were produced in the same manner as in Example 1 except that calcium carbonate having an average particle diameter of 0.15 µm was used as an inorganic filler, and measured in terms of their glossiness. The measurement results are shown in Table 1.

### (Example 3)

A base material and a light reflector were produced in the same manner as in Example 1 except that calcium carbonate having an average particle diameter of 0.2 µm was used as an inorganic filler, and measured in terms of their glossiness. The measurement results are shown in Table 1.

### (Example 4)

A base material and a light reflector were produced in the same manner as in Example 1 except that calcium carbonate having an average particle diameter of 0.3 µm was used as an inorganic filler, and measured in terms of their glossiness. The measurement results are shown in Table 1.

### (Comparative Example 1)

A base material and a light reflector were produced in the same manner as in Example 1 except that no inorganic filler was incorporated into the polyester resin composition, and measured in terms of their glossiness. The measurement results are shown in Table 1.

### (Comparative Example 2)

A base material and a light reflector were produced in the same manner as in Example 1 except that calcium carbonate having an average particle diameter of 0.08 µm was used as an inorganic filler, and measured in terms of their glossiness. The measurement results are shown in Table 1.

### (Comparative Example 3)

A base material and a light reflector were produced in the same manner as in Example 1 except that calcium carbonate having an average particle diameter of 0.5 µm was used as an inorganic filler, and measured in terms of their glossiness. The measurement results are shown in Table 1.

### (Comparative Example 4)

A base material and a light reflector were produced in the same manner as in Example 1 except that talc having an average particle diameter of 2 µm was used as an inorganic filler, and measured in terms of their glossiness. The measurement results are shown in Table 1.

### (Comparative Example 5)

A base material and a light reflector were produced in the same manner as in Example 1 except that clay having an average particle diameter of 0.8 µm was used as an inorganic filler, and measured in terms of their glossiness. The measurement results are shown in Table 1.

**[Table 1]**

| | Inorganic Filler | | Base Material Glossiness | | Light Reflector Glossiness |
|---|---|---|---|---|---|
| | Type | Average Particle Diameter (µm) | Before Heat Treatment | After Heat Treatment | |
| Comp.Ex.1 | - | - | 97.4 | 53.0 | 92 |
| Comp.Ex.2 | calcium carbonate | 0.08 | 98.5 | 70.0 | 106 |
| Ex. 1 | | 0.1 | 98.8 | 77.0 | 120 |
| Ex. 2 | | 0.15 | 98.9 | 77.3 | 122 |
| Ex. 3 | | 0.2 | 99.0 | 77.5 | 121 |
| Ex. 4 | | 0.3 | 98.8 | 77.4 | 120 |
| Comp.Ex.3 | | 0.5 | 98.0 | 69.0 | 105 |
| Comp.Ex.4 | talc | 2 | 95.0 | 60.0 | 95 |
| Comp.Ex.5 | clay | 0.8 | 95.5 | 65.0 | 99 |

It can be seen that, as shown in Table 1, the glossiness of the base material after the heat treatment significantly decreases as compared to that before the heat treatment. This can be attributed to the fact that the surface smoothness is lost by the heat treatment. Particularly in Comparative Example 1 in which no inorganic filler was incorporated, the glossiness of the base material after the heat treatment significantly decreased. It can also be seen that, with the use of talc or clay, the rate of decrease of glossiness of the base material after the heat treatment is large as compared to that with the use of calcium carbonate.

It can be seen that, as shown in Table 1, the base materials in Examples 1 to 4 in which calcium carbonate having an average particle diameter of 0.1 to 0.3 µm was used had high glossiness even after the heat treatment as compared to the base material in Comparative Example 2 in which calcium carbonate having an average particle diameter of 0.08 µm was used and the base material in Comparative Example 3 in which calcium carbonate having an average particle diameter of 0.5 µm was used. Likewise, also in terms of the glossiness of the light reflectors, Examples 1 to 4 in which calcium carbonate having an average particle diameter of 0.1 to 0.3 µm was used exhibited high values as compared to Comparative Example 2 in which calcium carbonate having an average particle diameter of 0.08 µm was used and Comparative Example 3 in which calcium carbonate having an average particle diameter of 0.5 µm was used.

Therefore, it can be seen that a light reflector can achieve high light intensity by incorporating therein calcium carbonate having an average particle diameter of 0.1 to 0.3 µm according to the present invention.

## Claims

1. A light reflector comprising a base material made of a polyester resin composition and a light reflection layer provided on the base material, wherein the polyester resin composition contains non-surface-treated synthetic calcium carbonate having an average particle diameter of 0.1 to 0.2 µm measured by image analysis of electron micrographs and having approximately cubic shape.

2. The light reflector according to claim 1, wherein the calcium carbonate is contained in an amount of 1 to 40 parts by mass per 100 parts by mass of polyester resin.

3. The light reflector according to claim 1 or 2, wherein the polyester resin contains polybutylene terephthalate resin.

4. The light reflector according to any one of claims 1 to 3, wherein the light reflection layer is a vapor-deposited metal film.

## Patentansprüche

1. Lichtreflektor, der ein Grundmaterial aus einer Polyesterharzzusammensetzung und eine Lichtreflexionsschicht umfasst, die auf dem Grundmaterial bereitgestellt ist, wobei die Polyesterharzzusammensetzung nicht oberflächenbehandeltes synthetisches Calciumcarbonat enthält, das einen durchschnittlichen Teilchendurchmesser von 0,1 bis 0,2 µm aufweist, gemessen durch Bildanalyse elektronenmikroskopischer Aufnahmen, und das eine annähernd kubische Form aufweist.

2. Lichtreflektor nach Anspruch 1, wobei das Calciumcarbonat in einer Menge von 1 bis 40 Massenteilen pro 100 Massenteile Polyesterharz enthalten ist.

3. Lichtreflektor nach Anspruch 1 oder 2, wobei das Polyesterharz Polybutylenterephthalatharz enthält.

4. Lichtreflektor nach einem der Ansprüche 1 bis 3, wobei die Lichtreflexionsschicht ein aufgedampfter Metallfilm ist.

## Revendications

1. Réflecteur de lumière comprenant un matériau de base constitué d'une composition de résine polyester et d'une couche de réflexion de lumière prévue sur le matériau de base, la composition de résine polyester contenant du carbonate de calcium synthétique non traité en surface ayant un diamètre de particule moyen de 0,1 à 0,2 µm mesuré par analyse d'image de micrographies électroniques et ayant une forme approximativement cubique.

2. Réflecteur de lumière selon la revendication 1, dans lequel le carbonate de calcium est contenu en une quantité de 1 à 40 parties en masse pour 100 parties en masse de résine polyester.

3. Réflecteur de lumière selon la revendication 1 ou 2, dans lequel la résine polyester contient une résine de polybutylène téréphtalate.

4. Réflecteur de lumière selon l'une quelconque des revendications 1 à 3, dans lequel la couche de réflexion de lumière est un film métallique déposé en phase vapeur.
